# EUROPEAN PATENT SPECIFICATION

(11) **EP 3 496 176 B1**
(45) Date of publication and mention of the grant of the patent: **22.04.2020**
(21) Application number: 18210235.0
(22) Date of filing: 04.12.2018
(51) Int. Cl.: H01L 51/52, H01L 27/32

(54) **ELECTROLUMINESCENT DISPLAY DEVICE**
ELEKTROLUMINESZIERENDE ANZEIGEVORRICHTUNG
AFFICHEUR ÉLECTROLUMINESCENT

(30) Priority: 05.12.2017 KR 20170166006
(43) Date of publication of application: 12.06.2019
(73) Proprietor: LG Display Co., Ltd., SEOUL, 07336 (KR)
(72) Inventor: LIM, Hyeong-Jun, 10845 Gyeonggi-do (KR); PARK, Han-Sun, 10845 Gyeonggi-do (KR); BANG, Hyung-Seok, 10845 Gyeonggi-do (KR); PARK, Ji-Yeon, 10845 Gyeonggi-do (KR)
(74) Representative: Ter Meer Steinmeister & Partner

(56) References cited:
- EP-A2- 2 731 156
- US-A1- 2006 202 613
- US-A1- 2015 188 092
- US-A1- 2016 087 245

## Description

### ELECTROLUMINESCENT DISPLAY DEVICE

This application claims the priority of Korean Patent Application No. 10-2017-0166006, filed on December 5, 2017, in the Korean Intellectual Property Office.

### BACKGROUND

### 1. Technical Field

The present disclosure relates to an electroluminescent display device.

### 2. Discussion of the Related Art

In recent years, flat panel displays having excellent characteristics such as being thin, lightweight, and having low power consumption have been widely developed and applied to various fields.

Among the flat panel displays, an electroluminescent display device is a device in which electrical charge carriers are injected into a light-emitting layer formed between a cathode, which is an electron-injecting electrode, and an anode, which is a hole-injecting electrode, such that excitons are formed, and then radiative recombination of the excitons occurs, thereby emitting light.

The electroluminescent display device can be formed using a flexible substrate such as plastic because it is self-luminous, and has excellent contrast ratios. Further the electroluminescent display device has a response time of several micro seconds, and there are advantages in displaying moving images. The electroluminescent display device also has wide viewing angles and is stable under low temperatures. Since the electroluminescent display device is driven by a low voltage of direct current DC 5V to 15V, it is easy to design and manufacture driving circuits.

Recently, as the size of substrates has been increased and display devices have evolved to have a high resolution, a pixel pitch has been decreased, and color mixture has become a problem.

EP 2 731 156 A2 relates to an organic light emitting diode (OLED) display which includes a first substrate, a wire unit, an organic light emitting diode, a second substrate, and a capping layer. There may be a plurality of color filters within the second substrate. The capping layer includes a plurality of high refractive patterns and a plurality of low refractive patterns. The high refractive pattern has a greater refractive index than the low refractive pattern.

US 2016/087245 A1 relates to an organic light emitting diode (OLED) display which includes a first substrate, a first electrode on the first substrate, a pixel defining layer having a first aperture exposing the first electrode, an organic light emitting layer on the first electrode, a second electrode on the organic light emitting layer, a second substrate that faces the first substrate, and a first filler and a second filler between the first and second substrates. The first filler is on the first aperture and has a higher refractive index than the second filler.

US 2015/188092 A1 discloses an organic light emitting diode display device. A resin layer including holes is formed on a substrate. In addition, sub-pixels including an organic light emitting cell are formed on the resin layer. The hole is formed between neighboring sub-pixels and the holes penetrate the resin layer.

In US 2006/202613 A1, an organic EL display is constituted by providing a stress-relieving layer made of a material having a higher elasticity and a lower refractive index than an adhesive layer at edges of color-converting filters that are constituted from color filter layers alone, or color filter layers and color-converting layers, and are formed on a transparent supporting substrate.

### SUMMARY

Accordingly, embodiments of the present disclosure are directed to an electroluminescent display device that substantially obviates one or more of the problems due to limitations and disadvantages of the related art.

It is an object of the present invention to provide an electroluminescent display device with high resolution in which light extraction efficiency is improved and color mixture is prevented.

The present invention is defined in the independent claim. Advantageous aspects of the invention are defined in the dependent claims.

To achieve the above-described object, the present disclosure provides an electroluminescent display device that preferably includes a substrate including a plurality of pixel regions; a plurality of light emitting diodes spaced apart from each other on the substrate and corresponding to the plurality of pixel regions, respectively; encapsulation film respectively covering the plurality of light emitting diodes and having a first refractive index; a first partition wall disposed between the encapsulation film corresponding to a boundary between the plurality of pixel regions and having a second refractive index lower than the first refractive index.

A color filter layer is disposed on the encapsulation film and the first partition wall, wherein the color filter layer includes a plurality of color filter patterns having a third refractive index and a second partition wall disposed between the plurality of color filter patterns and having a fourth refractive index lower than the third refractive index.

The second partition wall is disposed corresponding to the first partition wall.

The plurality of color filter patterns are disposed to correspond to the plurality of light emitting diodes, respectively.

In some embodiments, a middle portion of each of the first partition wall and the second partition wall has a bar shape.

Preferably, an upper portion of each of the first partition wall and the second partition wall has a width which progressively increases upward.

In some embodiments, a width of the middle portion of each of the first partition wall and/or the second partition wall is in a range of 2 µm to 3 µm.

In some embodiments, a height of each of the first partition wall and/or the second partition wall is in a range of 7 µm to 9 µm.

In some embodiments, each of the second refractive index and/or the fourth refractive index is in a range of 1.0 to 1.55.

In some embodiments, the color filter layer further includes a scattering layer disposed on an upper surface of each of the plurality of color filter patterns.

In some embodiments, an edge of each of the plurality of color filter patterns is curved.

In some embodiments, each of the plurality of light emitting diodes includes: a first electrode disposed on a passivation layer; an insulating pattern configured to cover an edge of the first electrode; a light-emitting layer disposed on the first electrode and the insulating pattern; and a second electrode disposed on the light-emitting layer.

In some embodiments, the electroluminescent display device further includes an interlayer insulating layer disposed under the passivation layer.

In some embodiments, the passivation layer and the interlayer insulating layer are separated for each pixel region by the first partition wall.

In some embodiments, the light emitting diodes are partitioned by holes in the passivation layer and the interlayer insulating layer.

In some embodiments, an encapsulation layer includes the encapsulation film having the first refractive index and the first partition wall having a second refractive index lower than the first refractive index.

In some embodiments, wherein a hole has different portions and configured to partition the pixel regions in the interlayer insulating layer and the passivation layer, wherein a width of a first portion is larger than a width of a second portion.

It is to be understood that both the foregoing general description and the following detailed description are by example and explanatory, and are intended to provide further explanation of the present disclosure as claimed.

### BRIEF DESCRIPTION OF THE DRAWINGS

The accompanying drawings, which are included to provide a further understanding of the present disclosure and which are incorporated in and constitute a part of this specification, illustrate embodiments of the present disclosure and together with the description serve to explain various principles of the present disclosure. In the drawings:
FIG. 1 is a circuit diagram illustrating a single pixel region of an electroluminescent display device according to the present disclosure.
FIG. 2 is a cross-sectional view schematically illustrating an electroluminescent display device according to a first embodiment of the present disclosure.
FIG. 3 is an enlarged view of a portion of an electroluminescent display device according to the first embodiment of the present disclosure.
FIG. 4 is a cross-sectional view schematically illustrating an electroluminescent display device according to a second embodiment of the present disclosure.
FIG. 5 is an enlarged view of a portion of the electroluminescent display device according to the second embodiment of the present disclosure.
FIG. 6 is a graph schematically illustrating light extraction efficiency according to refractive indices of first and second partition walls according to the first and second embodiments of the present disclosure.

### DETAILED DESCRIPTION

Hereinafter, exemplary embodiments of the present disclosure will be described with reference to the accompanying drawings.

### <First embodiment>

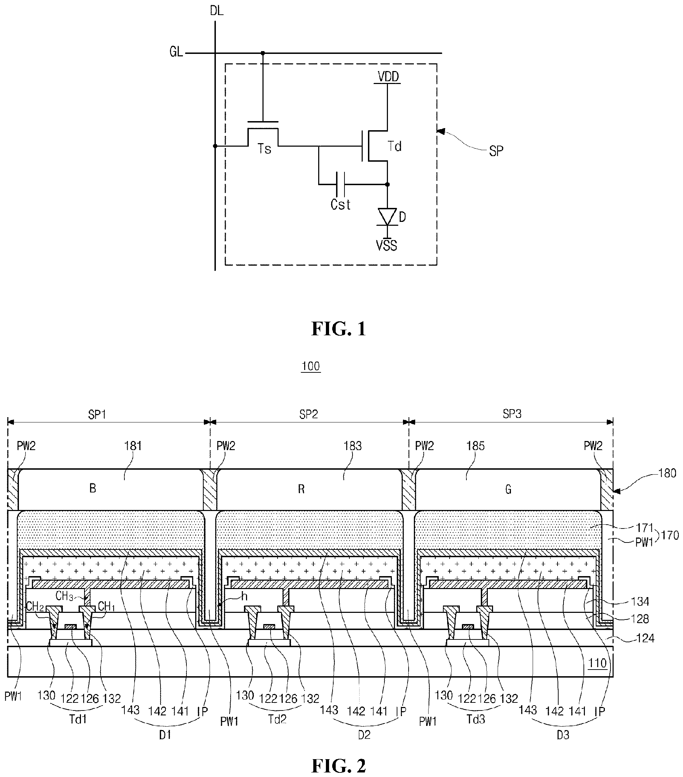

FIG. 1 is a circuit diagram illustrating a single pixel region of an electroluminescent display device according the present disclosure.

As illustrated in FIG. 1, the electroluminescent display device according to the embodiment of the present disclosure includes a gate line GL, a data line DL, a switching thin film transistor Ts, a driving thin film transistor Td, a storage capacitor Cst and a light-emitting diode D. The gate line GL and the data line DL cross each other to define a pixel region SP. The switching thin film transistor Ts, the driving thin film transistor Td, the storage capacitor Cst and the light-emitting diode D are formed in the pixel region SP.

More specifically, a gate electrode of the switching thin film transistor Ts is connected to the gate line GL and a source electrode of the switching thin film transistor Ts is connected to the data line DL. A gate electrode of the driving thin film transistor Td is connected to a drain electrode of the switching thin film transistor Ts, and a source electrode of the driving thin film transistor Td is connected to a high voltage supply VDD. An anode of the light-emitting diode D is connected to a drain electrode of the driving thin film transistor Td, and a cathode of the light-emitting diode D is connected to a low voltage supply VSS. The storage capacitor Cst is connected to the gate electrode and the drain electrode of the driving thin film transistor Td.

The electroluminescent display device is driven to display an image. For example, when the switching thin film transistor Ts is turned on by a gate signal applied through the gate line GL, a data signal from the data line DL is applied to the gate electrode of the driving thin film transistor Td and an electrode of the storage capacitor Cst through the switching thin film transistor Ts.

When the driving thin film transistor Td is turned on by the data signal, an electric current flowing through the light-emitting diode D is controlled, thereby displaying an image. The light-emitting diode D emits light due to the current supplied through the driving thin film transistor Td from the high voltage supply VDD.

That is, the amount of the current flowing through the light-emitting diode D is proportional to the magnitude of the data signal, and the intensity of light emitted by the light-emitting diode D is proportional to the amount of the current flowing through the light-emitting diode D. Thus, pixel regions SP show different gray levels depending on the magnitude of the data signal, and as a result, the electroluminescent display device displays an image.

The storage capacitor Cst maintains charges corresponding to the data signal for a frame when the switching thin film transistor Ts is turned off. Accordingly, even if the switching thin film transistor Ts is turned off, the storage capacitor Cst allows the amount of the current flowing through the light-emitting diode D to be constant and the gray level shown by the light-emitting diode D to be maintained until a next frame.

A transistor and/or a capacitor other than the switching and driving thin film transistors Ts and Td and the storage capacitor Cst may be further added in the pixel region SP.

FIG. 2 is a cross-sectional view schematically illustrating an electroluminescent display device according to a first embodiment of the present disclosure.

As illustrated in FIG. 2, an electroluminescent display device 100 according to the first embodiment of the present disclosure may include a substrate 110, thin film transistors Td1, Td2, and Td3 and light emitting diodes D1, D2, and D3 respectively formed in pixel regions SP1, SP2, and SP3 disposed on the substrate 110, an encapsulation layer 170 disposed on the light emitting diodes D1, D2, and D3, and a color filter layer 180 disposed on the encapsulation layer 170.

That is, the thin film transistors Td1, Td2, and Td3 and the light emitting diodes D1, D2, and D3 may be respectively formed in the pixel regions SP1, SP2, and SP3 on the substrate 110, which is also referred to as a lower substrate, a thin film transistor (TFT) substrate, or a backplane.

In this case, each of the pixel regions SP1, SP2, and SP3 refers to a unit in which a specific type of color filter pattern among color filter patterns 181, 183, and 185 is formed and thus a specific color may be emitted.

For example, the pixel regions SP1, SP2, and SP3 may include a blue pixel region SP1, a red pixel region SP2, and a green pixel region SP3, but are not limited thereto, and may further include a white pixel region.

Specifically, a semiconductor layer 122 may be formed in each of the pixel regions SP1, SP2, and SP3. A gate insulating layer 124 may be formed on the semiconductor layer 122 substantially all over the substrate 110 including the pixel regions SP1, SP2, and SP3. The semiconductor layer 122 may include an active area which is formed of an intrinsic semiconductor material and disposed at the center of the semiconductor layer 122, and a source area and a drain area which are formed of an impurity-doped semiconductor material and respectively formed at left and right positions of the active area.

A gate electrode 126 is formed on the gate insulating layer 124 corresponding to the semiconductor layer 122, and an interlayer insulating layer 128 is formed on the gate electrode 126. The interlayer insulating layer 128 and the gate insulating layer 124 may include first and second contact holes CH1 and CH2 configured to respectively expose the source area and the drain area of the semiconductor layer 122.

A source electrode 132 and a drain electrode 130 spaced apart from each other are formed on the interlayer insulating layer 128 corresponding to the semiconductor layer 122, and the source electrode 132 and the drain electrode 130 may be respectively connected to the source area and the drain area of the semiconductor layer 122 through the first and second contact holes CH1 and CH2.

In this case, the semiconductor layer 122, the gate electrode 126, the source electrode 132, and the drain electrode 130 formed in each of the pixel regions SP1, SP2, and SP3 may constitute each of the thin film transistors Td1, Td2, and Td3.

Although coplanar type thin film transistors Td1, Td2, and Td3 have been illustrated in FIG. 2 as an example, embodiments are not limited thereto, and staggered type thin film transistors may also be formed.

Although only the driving thin film transistors Td1, Td2, and Td3 are illustrated in FIG. 2, a plurality of thin film transistors such as the switching thin film transistor Ts of FIG. 2 having the same structure as the driving thin film transistors Td1, Td2, and Td3 may be formed in a single pixel region.

Although not illustrated in Fig. 2, a gate line GL of FIG. 1, a data line DL of FIG. 1 and a power line crossing each other to define the pixel regions SP1, SP2, and SP3 may be formed. The switching thin film transistor Ts of FIG. 1 may be connected to the gate line GL of FIG. 1 and the data line DL of FIG. 1, and each driving thin film transistor Td1, Td2, and Td3 may be connected to the switching thin film transistor Ts of FIG. land the power line.

A passivation layer 134 is formed on each of the thin film transistors Td1, Td2, and Td3. The passivation layer 134 may include a third contact hole CH3 configured to expose the source electrode 132.

An overcoat layer may be disposed on the passivation layer 134. In this case, the passivation layer 134 and the overcoat layer may include the third contact hole CH3 exposing the source electrode 132.

Here, holes h configured to partition the pixel regions SP1, SP2, and SP3 may be formed in the passivation layer 134 and the interlayer insulating layer 128. That is, the light emitting diodes D1, D2, and D3 may be partitioned by the holes h in the passivation layer 134 and the interlayer insulating layer 128 so that the light emitting diodes D1, D2, and D3 respectively correspond to the pixel regions SP1, SP2, and SP3. The light emitting diodes D1, D2, and D3 may be spaced apart from each other and respectively disposed in the pixel regions SP1, SP3, and SP3.

Although the holes h are illustrated as being formed in the passivation layer 134 and the interlayer insulating layer 128 in FIG. 2, this is merely an example. The electroluminescent display device 100 may have various other structures in which holes h capable of partitioning the light emitting diodes D1, D2, and D3 corresponding to the pixel regions SP1, SP2, and SP3 are formed.

Such holes h may be formed by performing a light-exposing process using a photo mask and a development process.

A first electrode 141 may be disposed on the passivation layer 134.

In this case, the first electrode 141 may be an anode or cathode for supplying one of holes or electrons to a light-emitting layer 142.

A case in which the first electrode 141 of the electroluminescent display device 100 according to the first embodiment of the present disclosure is an anode will be described as an example.

The first electrode 141 may be formed as a single layer of a transparent conductive material such as indium tin oxide (ITO). Alternatively, the first electrode 141 may be formed of a conductive material with relatively high reflectance such as a laminated structure of aluminum and titanium (Ti/Al/Ti), a laminated structure of Al and ITO (ITO/Al/ITO), an APC alloy, and a laminated structure of the APC alloy and ITO (ITO/APC/ITO) in order to obtain a micro cavity effect. The APC alloy refers to an alloy of silver (Ag), palladium (Pd), and copper (Cu).

The first electrode 141 may be connected to the source electrode 132 of each of the thin film transistors Td1, Td2, and Td3 through the third contact hole CH3 formed in the passivation layer 134 and may be separately formed in each of the pixel regions SP1, SP2, and SP3.

Although the electroluminescent display device 100 according to the first embodiment of the present disclosure has been described by assuming that the thin film transistors Td1, Td2, and Td3 are N-type thin film transistors and the first electrode 141 is connected to the source electrode 132, embodiments are not limited thereto. When the thin film transistors Td1, Td2, and Td3 are P-type thin film transistors, the first electrode 141 may be connected to the drain electrode 130.

An insulating pattern IP configured to cover an edge of the first electrode 141 may be disposed on the first electrode 141. That is, the insulating pattern IP may be disposed to cover a side surface and a portion of an upper surface of the first electrode 141.

The insulating pattern IP may be formed of silicon oxide, but embodiments are not limited thereto.

In this case, the insulating pattern IP may mitigate a step difference of the first electrode 141 and improve current efficiency. That is, when forming the light-emitting layer 142 on the first electrode 141, the light-emitting layer 142 is formed to have a relatively small thickness on a stepped area of the first electrode 141 so that a current which does not contribute to emission is prevented from being focused.

The light-emitting layer 142 may be disposed on the first electrode 141 and the insulating pattern IP.

In this case, the light-emitting layer 142 may emit white light. For example, the light-emitting layer 142 may have a tandem white structure in which a plurality of light-emitting layers are stacked to emit white light. For example, the light-emitting layer 142 may include a first light-emitting layer configured to emit blue light and a second light-emitting layer disposed on the first light-emitting layer and configured to emit light having a color which turns white when mixed with blue. The second light-emitting layer may be a light-emitting layer configured to emit yellow-green light. However, embodiments are not limited thereto, and a light-emitting layer 142 configured to emit one of blue light, red light, and green light may be disposed in each of the pixel regions SP1, SP2, and SP3.

A luminescent material of the light-emitting layer 142 may be an organic luminescent material having a refractive index of about 1.8 or higher or an inorganic luminescent material such as a quantum dot.

Also, the light-emitting layer 142 may be disposed in a shape which follows the morphology of the entire surfaces of the pixel regions SP1, SP2, and SP3.

That is, the light-emitting layer 142 may be disposed in a shape which follows the morphology of the first electrode 141 and the insulating pattern IP formed in each of the pixel regions SP1, SP2, and SP3 and the holes h formed in the passivation layer 134 and the interlayer insulating layer 128.

A second electrode 143 for supplying one of electrons or holes to the light-emitting layer 142 may be disposed on the light-emitting layer 142.

Here, the second electrode 143 may be a cathode or an anode.

A case in which the second electrode 143 of the electroluminescent display device 100 according to the first embodiment of the present disclosure is a cathode will be described as an example.

In this case, the second electrode 143 is formed along the morphology of the light-emitting layer 142. That is, the second electrode 143 may be formed to cover the light-emitting layer 142 along the shape of the light-emitting layer 142.

The second electrode 143 may be formed of a transparent conductive material such as ITO and IZO capable of transmitting light or may be formed of a semi-transmissive conductive material such as magnesium (Mg), silver (Ag), or an alloy of Mg and Ag.

Accordingly, the first electrode 141, the insulating pattern IP, the light-emitting layer 142, and the second electrode 143 may overlap with each other and form each of the light emitting diodes D1, D2, and D3, and the light emitting diodes D1, D2, and D3 may be spaced apart from each other and be disposed corresponding to the pixel regions SP1, SP2, and SP3, respectively.

The encapsulation layer 170 may be disposed on the light emitting diodes D1, D2, and D3 formed corresponding to the pixel regions SP1, SP2, and SP3, respectively.

The encapsulation layer 170 of the electroluminescent display device 100 according to the first embodiment of the present disclosure includes an encapsulation film 171 having a first refractive index and a first partition wall PW1 having a second refractive index lower than the first refractive index.

In this case, the encapsulation film 171 may be formed along the morphology of the light emitting diodes D1, D2, and D3 formed to corresponding to the pixel regions SP1, SP2, and SP3, respectively. That is, the encapsulation film 171 may be formed along the morphology of the second electrode 143 disposed at the uppermost portions of the light emitting diodes D1, D2, and D3.

Due to the encapsulation film 171 being disposed along the morphology of the second electrode 143, a groove may be formed in the encapsulation film 171 corresponding to a boundary between the pixel regions SP1, SP2, and SP3.

In this case, the encapsulation film 171 may be formed of an inorganic film and/or may have a multilayer structure.

For example, the encapsulation film 171 may include at least one layer formed of silicon nitride, aluminum nitride, zirconium nitride, titanium nitride, hafnium nitride, tantalum nitride, silicon oxide, aluminum oxide, or titanium oxide.

The first partition wall PW1, which is bar-shaped, may be disposed in the groove of the encapsulation film 171 corresponding to the boundary between the pixel regions SP1, SP2, and SP3.

Although a width of an upper portion of the first partition wall PW1 is illustrated in the drawings as progressively increasing, this is merely an example, and the first partition wall PW1 may have the same width throughout.

The first partition wall PW1 may be an organic material having the second refractive index lower than the first refractive index of the encapsulation film 171. For example, the first refractive index may be in a range of 1.56 to 1.85, and the second refractive index may be in a range of 1.0 to 1.55, but embodiments are not limited thereto.

Due to the first partition wall PW1 having a refractive index lower than that of the encapsulation film 171, light that is incident obliquely on the encapsulation film 171 from the light-emitting layer 142 of the light emitting diodes D1, D2, and D3 may be reflected by the first partition wall PW1 and be output to upper areas of the corresponding pixel regions SP1, SP2, and SP3. Accordingly, light extraction efficiency of the electroluminescent display device 100 may be improved, and color mixture may be prevented.

In addition, permeation of oxygen or moisture into the light-emitting layer 142 and the second electrode 143 may be more effectively prevented by the encapsulation films 171 and the first partition walls PW1 disposed between the encapsulation films 171 configured to cover the light emitting diodes D1, D2, and D3.

The color filter layer 180 may be disposed on the encapsulation layer 170.

In this case, the color filter layer 180 includes the color filter patterns 181, 183, and 185 which patterns are formed corresponding to the pixel regions SP1, SP2, and SP3, respectively, and a bar-shaped second partition wall PW2 is disposed between the color filter patterns 181, 183, and 185.

Although a width of an upper portion of the second partition wall PW2 is illustrated in the drawings as progressively increasing, this is merely an example, and the second partition wall PW2 may have the same width throughout.

The color filter patterns 181, 183, and 185 have a third refractive index, and the second partition wall PW2 has a fourth refractive index lower than the third refractive index.

In this case, the third refractive index may be in a range of 1.6 to 1.85, and the fourth refractive index may be in a range of 1.0 to 1.55, but embodiments are not limited thereto.

The second partition wall PW2 may be formed of silicon oxide, but embodiments are not limited thereto.

Due to the second partition wall PW2 having a refractive index lower than that of the color filter patterns 181, 183, and 185, light that is incident obliquely on the color filter patterns 181, 183, and 185 from the light-emitting layer 142 of the light emitting diodes D1, D2, and D3 may be reflected by the second partition wall PW2 and be output to upper areas of the corresponding pixel regions SP1, SP2, and SP3. Accordingly, a problem in which color mixture occurs in a viewing angle direction may be prevented.

Further, since the second partition wall PW2 between the color filter patterns 181, 183, and 185 has a relatively fine width, an emissive area may be increased in comparison to a conventional case in which a black matrix is disposed.

Particularly, the second partition wall PW2 of the electroluminescent display device according to the first embodiment of the present disclosure may be formed corresponding to the first partition wall PW1. That is, the first partition wall PW1 and the second partition wall PW2 may be disposed to be parallel to each other in a first direction perpendicular to the substrate 110.

Due to the first partition wall PW1 and the second partition wall PW2 being disposed to be parallel to each other in the first direction, light that is output from the light emitting diodes D1, D2, and D3 respectively formed in the pixel regions SP1, SP2, and SP3 may be output to upper areas of the corresponding pixel regions SP1, SP2, and SP3. Accordingly, light extraction efficiency may be improved, and color mixture may be effectively prevented.

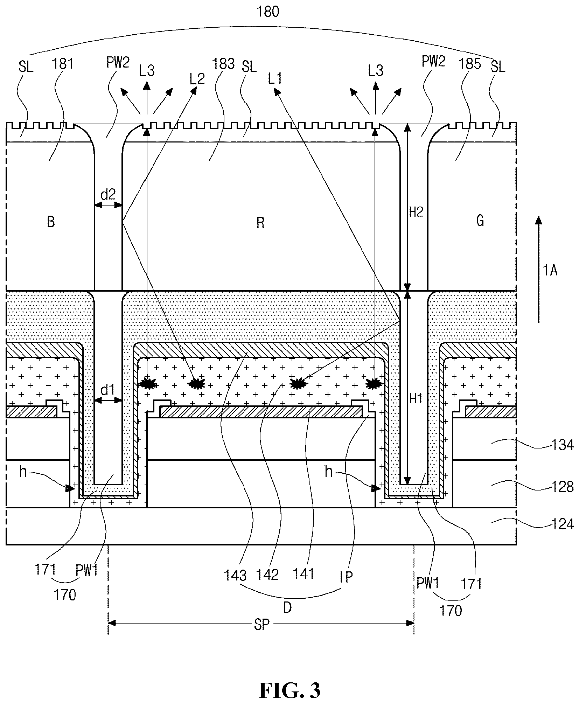

FIG. 3 is an enlarged view of a portion of an electroluminescent display device according to the first embodiment of the present disclosure.

As illustrated in FIG. 3, the electroluminescent display device 100 of FIG. 2 according to the first embodiment of the present disclosure may include a substrate 110 of FIG. 2, light emitting diodes D disposed on the substrate 110 of FIG. 2, an encapsulation layer 170 disposed on the light emitting diodes D, and a color filter layer 180 disposed on the encapsulation layer 170.

An interlayer insulating layer 128 and a passivation layer 134 may be disposed between the substrate 110 of FIG. 2 and the light emitting diodes D.

In this case, since holes h configured to partition pixel regions SP are formed in the passivation layer 134 and the interlayer insulating layer 128, the light emitting diodes D may be formed corresponding to the pixel regions SP.

That is, due to the holes h formed in the passivation layer 134 and the interlayer insulating layer 128, a bank layer which is formed in a conventional electroluminescent display device in order to partition pixel regions SP may be omitted, and a process may be simplified.

A first electrode 141 may be disposed on the passivation layer 134, and an insulating pattern IP configured to cover an edge of the first electrode 141 may be disposed on the first electrode 141.

When forming a light-emitting layer 142 on the first electrode 141 using the insulating pattern IP, the light-emitting layer 142 is formed to have a relatively small thickness on a stepped area of the first electrode 141 so that a current which does not contribute to emission is prevented from being focused, and current efficiency is improved.

The light-emitting layer 142 may be disposed on the first electrode 141 and the insulating pattern IP.

In this case, the light-emitting layer 142 may be disposed in a shape which follows the morphology of the first electrode 141, the insulating pattern IP, and the holes h formed in the passivation layer 134 and the interlayer insulating layer 128.

A second electrode 143 may be disposed on the light-emitting layer 142.

In this case, the second electrode 143 may be disposed in a shape which follows the morphology of the light-emitting layer 142.

Accordingly, the first electrode 141, the insulating pattern IP, the light-emitting layer 142, and the second electrode 143 may form the light emitting diodes D, and adjacent light emitting diodes D may be spaced apart from each other and be disposed corresponding to the pixel regions SP.

The encapsulation layer 170, which includes an encapsulation film 171 having a first refractive index and a first partition wall PW1 having a second refractive index lower than the first refractive index, may be disposed on the light emitting diodes D.

Particularly, the encapsulation film 171 may be formed along the morphology of the light emitting diodes D. That is, the encapsulation film 171 may be formed along the morphology of the second electrode 143 disposed at the uppermost portions of the light emitting diodes D.

Due to the encapsulation film 171 being disposed along the morphology of the second electrode 143, the electroluminescent display device 100 may have a structure in which the encapsulation film 171 covers each of the light emitting diodes D, and thus permeation of oxygen or moisture into the light-emitting layer 142 and the second electrode 143 may be more effectively prevented.

In this case, the encapsulation film 171 may be formed of an inorganic film and/or may have a multilayer structure.

The first partition wall PW1 may be disposed in the groove of the encapsulation film 171 corresponding to the boundary between the pixel regions SP.

A middle portion of the first partition wall PW1 may have a bar shape, and an upper portion of the first partition wall PW1 may have a shape in which a width progressively increases upward. However, this is merely an example, and the first partition wall PW1 may be formed such that the upper portion and the middle portion have the same width.

In this case, a width d1 of the middle portion of the first partition wall PW1 may be in a range of 2 µm to 3 µm. The width of the upper portion of the first partition wall PW1 may be larger than or equal to the width d1 of the middle portion of the first partition wall PW1. However, embodiments are not limited thereto, and the widths of the upper portion and the middle portion of the first partition wall PW1 may be modified in various ways according to the size, resolution, and the like of the pixel regions SP.

Also, a height HI of the first partition wall PW1 may be in a range of 7 µm to 9 µm, but embodiments are not limited thereto. The height HI may be modified in various ways according to a thickness or the like of the passivation layer 134, the interlayer insulating layer 128, and the light emitting diodes D.

The passivation layer 134 and the interlayer insulating layer 128 may be separated corresponding to the pixel regions SP by the first partition wall PW1.

In this case, the first partition wall PW1 may be an organic material having a second refractive index lower than the first refractive index of the encapsulation film 171. For example, the first refractive index may be in a range of 1.6 to 1.85, and the second refractive index may be in a range of 1.0 to 1.55, but embodiments are not limited thereto.

Due to the first partition wall PW1 having a refractive index lower than that of the encapsulation film 171, light that is incident obliquely on the encapsulation film 171 from the light-emitting layer 142 of the light emitting diodes D may be reflected by the first partition wall PW1 and be output to upper areas of the corresponding pixel regions SP. Accordingly, light extraction efficiency of the electroluminescent display device 100 may be improved, and color mixture may be prevented.

By forming the first partition wall PW1 between the encapsulation films 171 configured to cover the light emitting diodes D, efficiency of preventing permeation of oxygen or moisture into the light-emitting layer 142 and the second electrode 143 may be further improved.

The color filter layer 180 may be disposed on the encapsulation layer 170.

In this case, the color filter layer 180 may include color filter patterns 181, 183, and 185 formed corresponding to the pixel regions SP and a second partition wall PW2 formed between the color filter patterns 181, 183, and 185.

That is, the color filter patterns 181, 183, and 185 may be disposed corresponding to the light emitting diodes D.

Consequently, when white light is output from the light emitting diodes D, the white light may be converted into specific colored light through the color filter patterns 181, 183, and 185.

Here, edges of the color filter patterns 181, 183, and 185 may be curved.

Further, when lights of different wavelength bands are output from the light emitting diodes D, the color filter patterns 181, 183, and 185 may be disposed corresponding to the light emitting diodes D so that the lights of different wavelength bands are prevented from being mixed and causing a blurring phenomenon and a ghost phenomenon.

The color filter patterns 181, 183, and 185 may have a third refractive index, and the second partition wall PW2 may have a fourth refractive index lower than the third refractive index.

In this case, the third refractive index may be in a range of 1.6 to 1.85, and the fourth refractive index may be in a range of 1.0 to 1.55, but embodiments are not limited thereto.

A middle portion of the second partition wall PW2 may have a bar shape, and an upper portion of the second partition wall PW2 may have a shape in which a width progressively increases upward.

A width d2 of the middle portion of the second partition wall PW2 may be in a range of 2 µm to 3 µm. The width of the upper portion of the second partition wall PW2 may be larger than or equal to the width d2 of the middle portion of the second partition wall PW2. However, embodiments are not limited thereto.

Also, a height H2 of the second partition wall PW2 may be in a range of 7 µm to 9 µm, but embodiments are not limited thereto. The height H2 may be modified in various ways according to a thickness or the like of the color filter patterns 181, 183, and 185.

The second partition wall PW2 may be formed of silicon oxide, but embodiments are not limited thereto. The second partition wall PW2 may also be formed of an air gap.

Due to the second partition wall PW2 having a refractive index lower than that of the color filter patterns 181, 183, and 185, light that is incident obliquely on the color filter patterns 181, 183, and 185 from the light-emitting layer 142 of the light emitting diodes D may be reflected by the second partition wall PW2 and be output to upper areas of the corresponding pixel regions SP. Accordingly, a problem in which color mixture occurs in a viewing angle direction may be prevented.

Further, since the second partition wall PW2 between the color filter patterns 181, 183, and 185 has a relatively fine width d2, an emissive area may be increased in comparison to the conventional case in which a black matrix is disposed.

A scattering layer SL may be disposed on an upper surface of each of the color filter patterns 181, 183, and 185.

In this case, the scattering layer SL may be a concavo-convex pattern formed on the upper surface of each of the color filter patterns 181, 183, and 185, but embodiments are not limited thereto. The scattering layer SL may also be formed of a material layer including beads.

Accordingly, light that passes through the color filter patterns 181, 183, and 185 and is output to the outside may be scattered in various directions.

Particularly, by scattering a portion of light L3, which is incident vertically on the color filter patterns 181, 183, and 185 at a boundary between the pixel regions SP, toward the second partition wall PW2, perception of lattices that may occur due to the fine second partition wall PW2 being viewed as a black area may be prevented when one views an image in a state in which one's eyes are close to a screen, such as when one views an image using a virtual reality (VR) device.

Particularly, the second partition wall PW2 of the electroluminescent display device 100 according to the first embodiment of the present disclosure may be formed corresponding to the first partition wall PW1.

That is, the first partition wall PW1 and the second partition wall PW2 may be disposed to be parallel to each other in a first direction 1A perpendicular to the substrate 110.

Due to the first partition wall PW1 and the second partition wall PW2 being disposed to be parallel to each other in the first direction 1A, light that is output from the light emitting diodes D respectively formed in the pixel regions SP may be output to upper areas of the corresponding pixel regions SP. Accordingly, light extraction efficiency may be improved, and color mixture may be effectively prevented.

### <Second embodiment>

Hereinafter, detailed descriptions of configurations identical or similar to those of the first embodiment may be omitted.

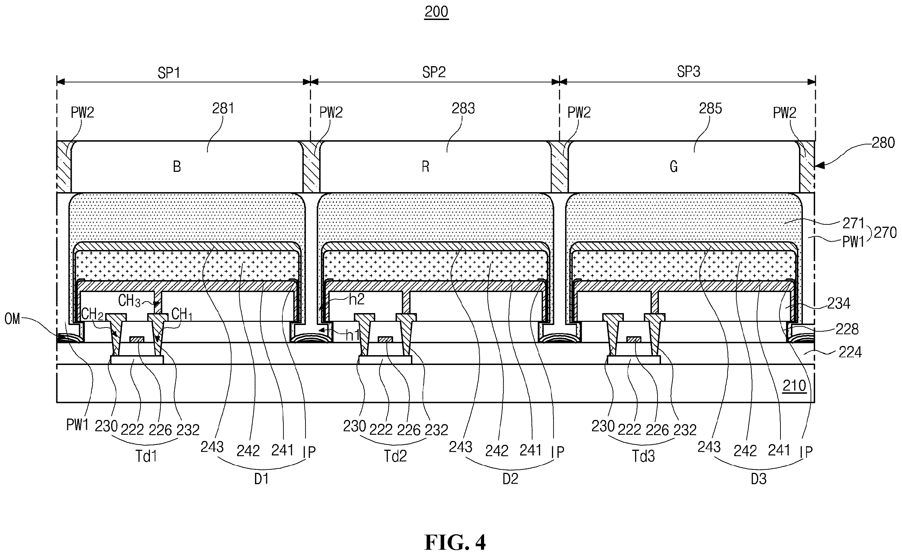

FIG. 4 is a cross-sectional view schematically illustrating an electroluminescent display device according to a second embodiment of the present disclosure.

As illustrated in FIG. 4, an electroluminescent display device 200 according to the embodiment of the present disclosure may include a substrate 210, thin film transistors Td1, Td2, and Td3 and light emitting diodes D1, D2, and D3 respectively formed in pixel regions SP1, SP2, and SP3 disposed on the substrate 210, an encapsulation layer 270 disposed on the light emitting diodes D1, D2, and D3, and the color filter layer 280 disposed on the encapsulation layer 270.

That is, the thin film transistors Td1, Td2, and Td3 and the light emitting diodes D1, D2, and D3 may be respectively formed in the pixel regions SP1, SP2, and SP3 on the substrate 210, which is also referred to as a lower substrate, a thin film transistor (TFT) substrate, or a backplane.

In this case, the pixel regions SP1, SP2, and SP3 may include a blue pixel region SP1, a red pixel region SP2, and a green pixel region SP3, but are not limited thereto, and may further include a white pixel region.

A semiconductor layer 222 may be formed in each of the pixel regions SP1, SP2, and SP3. A gate insulating layer 224 may be formed on the semiconductor layer 222 substantially all over the substrate 110 including the pixel regions SP1, SP2, and SP3.

A gate electrode 226 is formed on the gate insulating layer 224 corresponding to the semiconductor layer 222, and an interlayer insulating layer 228 is formed on the gate electrode 226. The interlayer insulating layer 228 and the gate insulating layer 224 may include first and second contact holes CH1 and CH2 configured to respectively expose the source area and the drain area of the semiconductor layer 222.

A source electrode 232 and a drain electrode 230 spaced apart from each other are formed on the interlayer insulating layer 228 corresponding to the semiconductor layer 222, and the source electrode 232 and the drain electrode 230 may be respectively connected to the source area and the drain area of the semiconductor layer 222 through the first and second contact holes CH1 and CH2.

In this case, the semiconductor layer 222, the gate electrode 226, the source electrode 232, and the drain electrode 230 formed in the pixel regions SP1, SP2, and SP3 may constitute the thin film transistors Td1, Td2, and Td3.

A passivation layer 234 is formed on each of the thin film transistors Td1, Td2, and Td3. The passivation layer 234 may include a third contact hole CH3 configured to expose the source electrode 232.

In this case, in the electroluminescent display device 200 according to the second embodiment of the present disclosure, holes h1 and h2 configured to partition the pixel regions SP1, SP2, and SP3 may be formed in the interlayer insulating layer 228 and the passivation layer 234. That is, the light emitting diodes D1, D2, and D3 may be partitioned by the holes h1 and h2 in the interlayer insulating layer 228 and the passivation layer 234 so that the light emitting diodes D1, D2, and D3 respectively correspond to the pixel regions SP1, SP2, and SP3. The light emitting diodes D1, D2, and D3 may be spaced apart from each other and respectively disposed in the pixel regions SP1, SP3, and SP3.

Particularly, in the electroluminescent display device 200 according to the second embodiment of the present disclosure, a width of a portion of the hole h1 formed in the interlayer insulating layer 228 may be larger than a width of a portion of the hole h1 formed in the passivation layer 234.

That is, the electroluminescent display device 200 has an under-cut form in which the width of the interlayer insulating layer 228 is smaller than the width of the passivation layer 234 disposed in each of the pixel regions SP1, SP2, and SP3.

Also, a first electrode 241 configured to cover an upper surface and a side surface of the passivation layer 234 may be disposed.

The first electrode 241 may be connected to the source electrode 232 of each of the thin film transistors Td1, Td2, and Td3 through the third contact hole CH3 formed in the passivation layer 234 and may be separately formed in each of the pixel regions SP1, SP2, and SP3.

Since the interlayer insulating layer 228 and the passivation layer 234 of the electroluminescent display device 200 according to the second embodiment of the present disclosure have the under-cut form, the first electrode 241 separately formed in each of the pixel regions SP1, SP2, and SP3 may be formed by one process so that the process may be simplified.

An insulating pattern IP configured to cover a side surface and a portion of an upper surface of the first electrode 241 may be disposed.

The insulating pattern IP may be formed of silicon oxide, but embodiments are not limited thereto.

In this case, the insulating pattern IP may mitigate a step difference of the first electrode 241 and improve current efficiency. That is, when forming a light-emitting layer 242 on the first electrode 241, the light-emitting layer 242 is formed to have a relatively small thickness on a stepped area of the first electrode 241 so that a current which does not contribute to emission is prevented from being focused.

The light-emitting layer 242 configured to cover the first electrode 241 and the insulating pattern IP may be disposed.

In this case, since the interlayer insulating layer 228 and the passivation layer 234 of the electroluminescent display device 200 according to the second embodiment of the present disclosure have the under-cut form, the light-emitting layer 242 separately formed in each of the pixel regions SP1, SP2, and SP3 may be formed by one process.

In this case, the light-emitting layer 242 may emit white light, but embodiments are not limited thereto. A light-emitting layer 242 configured to emit one of blue light, red light, and green light may be disposed in each of the pixel regions SP1, SP2, and SP3.

A luminescent material of the light-emitting layer 242 may be an organic luminescent material having a refractive index of about 1.8 or higher or an inorganic luminescent material such as a quantum dot.

A second electrode 243 configured to cover an upper surface and a side surface of the light-emitting layer 242 may be disposed.

Although the second electrode 243 is illustrated as if the second electrode 243 is formed separately in each of the pixel regions SP1, SP2, and SP3 in FIG. 4, the second electrodes 243 may be connected to each other in a cross-sectional view taken along a direction perpendicular to that of the cross-sectional view illustrated in FIG. 4.

Accordingly, the first electrode 241, the insulating pattern IP, the light-emitting layer 242, and the second electrode 243 form each of the light emitting diodes D1, D2, and D3, and the light emitting diodes D1, D2, and D3 may be spaced apart from each other and be disposed corresponding to the pixel regions SP1, SP2, and SP3, respectively.

The encapsulation layer 270 may be disposed on the light emitting diodes D1, D2, and D3 formed corresponding to the pixel regions SP1, SP2, and SP3, respectively.

The encapsulation layer 270 of the electroluminescent display device 200 according to the second embodiment of the present disclosure includes an encapsulation film 271 having a first refractive index and a first partition wall PW1 having a second refractive index lower than the first refractive index.

In this case, the encapsulation film 271 is disposed in the form in which the encapsulation film 271 covers each of the light emitting diodes D1, D2, and D3 formed corresponding to each of the pixel regions SP1, SP2, and SP3.

In this case, the encapsulation film 271 may be formed of an inorganic film and/or have a multilayer structure.

A residual layer OM may be present between the light emitting diodes D1, D2, and D3.

In this case, the residual layer OM is formed from materials, which are to be used in forming the light emitting diodes D1, D2, and D3 and the encapsulation film 271, remaining in the hole h1 of the interlayer insulating layer 228.

The first partition wall PW1 may be disposed between the encapsulation films 271 corresponding to the boundary between the pixel regions SP1, SP2, and SP3.

Although a middle portion of the first partition wall PW1 is illustrated as having a bar shape and an upper portion of the first partition wall PW1 is illustrated as having a shape in which a width progressively increases in the drawings, this is merely an example. The first partition wall PW1 may be formed such that the upper portion and the middle portion have the same width.

Also, a lower portion of the first partition wall PW1 of the electroluminescent display device 200 according to the second embodiment of the present disclosure may be formed to have a width larger than that of the middle portion, and a lower surface of the first partition wall PW1 may contact the residual layer OM.

The first partition wall PW1 may be an organic material having a second refractive index lower than the first refractive index of the encapsulation film 271. For example, the first refractive index may be in a range of 1.6 to 1.85, and the second refractive index may be in a range of 1.0 to 1.55, but embodiments are not limited thereto.

Due to the first partition wall PW1 having a refractive index lower than that of the encapsulation film 271, light that is incident obliquely on the encapsulation film 271 from the light-emitting layer 242 of the light emitting diodes D1, D2, and D3 may be reflected by the first partition wall PW1 and be output to upper areas of the corresponding pixel regions SP1, SP2, and SP3. Accordingly, light extraction efficiency of the electroluminescent display device 200 may be improved, and color mixture may be prevented.

In addition, permeation of oxygen or moisture into the light-emitting layer 242 and the second electrode 243 may be more effectively prevented by the encapsulation films 271 and the first partition wall PW1 disposed between the encapsulation films 271 configured to cover the light emitting diodes D1, D2, and D3.

By the width of the lower portion of the first partition wall PW1 being formed larger than the width of the middle portion thereof and the lower surface of the first partition wall PW1 having a structure in which the lower surface contacts the residual layer OM, efficiency of preventing permeation of oxygen and moisture may be further improved.

The color filter layer 280 may be disposed on the encapsulation layer 270.

In this case, the color filter layer 280 includes color filter patterns 281, 283, and 285 formed corresponding to the pixel regions SP1, SP2, and SP3, respectively, and second partition walls PW2 formed between the color filter patterns 281, 283, and 285.

In this case, edges of the color filter patterns 281, 283, and 285 may be curved.

The color filter patterns 281, 283, and 285 have a third refractive index, and the second partition wall PW2 may have a fourth refractive index lower than the third refractive index.

In this case, the third refractive index may be in a range of 1.6 to 1.85, and the fourth refractive index may be in a range of 1.0 to 1.55, but embodiments are not limited thereto.

The second partition wall PW2 may be formed of silicon oxide, but embodiments are not limited thereto.

Due to the second partition wall PW2 having a refractive index lower than that of the color filter patterns 281, 283, and 285, light that is incident obliquely on the color filter patterns 281, 283, and 285 from the light-emitting layer 242 of the light emitting diodes D1, D2, and D3 may be reflected by the second partition wall PW2 and be output to upper areas of the corresponding pixel regions SP1, SP2, and SP3. Accordingly, a problem in which color mixture occurs in a viewing angle direction may be prevented.

Further, since the second partition wall PW2 between the color filter patterns 281, 283, and 285 has a relatively fine width, an emissive area may be increased in comparison to a conventional case in which a black matrix is disposed.

Particularly, the second partition wall PW2 of the electroluminescent display device 200 according to the second embodiment of the present disclosure are formed corresponding to the first partition wall PW1.

That is, the first partition wall PW1 and the second partition wall PW2 may be disposed to be parallel to each other in a first direction perpendicular to the substrate 210.

Due to the first partition wall PW1 and the second partition wall PW2 being disposed to be parallel to each other in the first direction, light that is output from the light emitting diodes D1, D2, and D3 respectively formed in the pixel regions SP1, SP2, and SP3 may be output to upper areas of the corresponding pixel regions SP1, SP2, and SP3. Accordingly, light extraction efficiency may be improved, and color mixture may be effectively prevented.

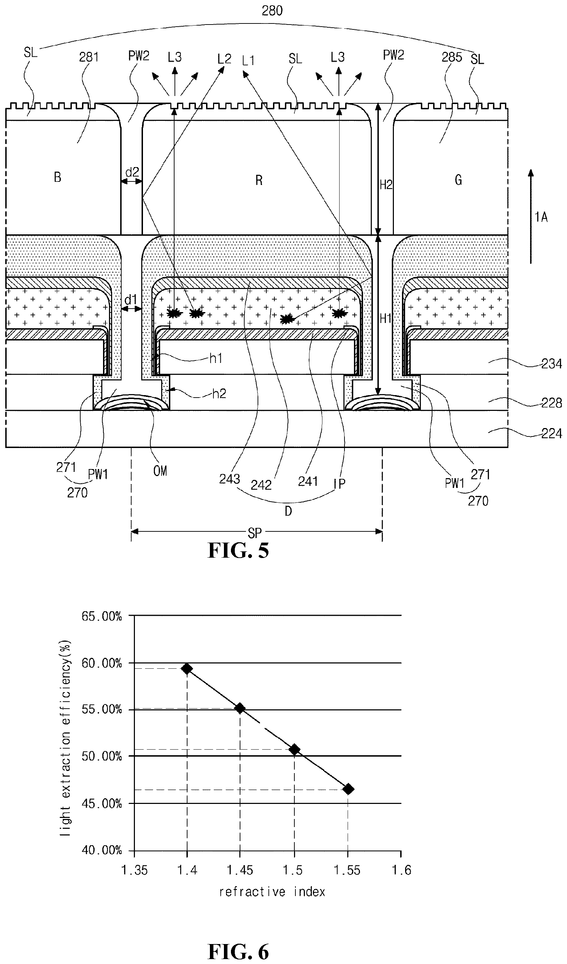

FIG. 5 is an enlarged view of a portion of an electroluminescent display device according to the second embodiment of the present disclosure.

As illustrated in FIG. 5, the electroluminescent display device 200 of FIG. 4 according to the second embodiment of the present disclosure may include a substrate 210 of FIG. 4, light emitting diodes D disposed on the substrate 210 of FIG. 4, a encapsulation layer 270 disposed on the light emitting diodes D, and a color filter layer 280 disposed on the encapsulation layer 270.

An interlayer insulating layer 228 and a passivation layer 234 may be disposed between the substrate 210 of FIG. 4 and the light emitting diodes D.

In this case, since holes h1 and h2 configured to partition pixel regions SP are formed in the interlayer insulating layer 228 and the passivation layer 234, the light emitting diodes D may be spaced apart from each other and disposed in the pixel regions SP, respectively.

Due to the holes h1 and h2 formed in the passivation layer 234 and the interlayer insulating layer 228, a bank layer which is formed in a conventional electroluminescent display device in order to partition pixel regions SP may be omitted, and a process may be simplified.

The electroluminescent display device 200 has an under-cut form in which the width of the interlayer insulating layer 228 is smaller than the width of the passivation layer 234 disposed in each of the pixel regions SP.

Also, a first electrode 241 configured to cover an upper surface and a side surface of the passivation layer 234 may be disposed.

In this case, since the interlayer insulating layer 228 and the passivation layer 234 have the under-cut form, the first electrode 241 separately formed in each of the pixel regions SP may be formed by one process so that the process may be simplified.

An insulating pattern IP configured to cover a side surface and a portion of an upper surface of the first electrode 241 may be disposed.

When forming a light-emitting layer 242 on the first electrode 241 using such an insulating pattern IP, the light-emitting layer 242 is formed to have a relatively small thickness on a stepped area of the first electrode 241 so that a current which does not contribute to emission is prevented from being focused. Accordingly, current efficiency may be improved.

The light-emitting layer 242 configured to cover the first electrode 241 and the insulating pattern IP may be disposed.

In this case, since the interlayer insulating layer 228 and the passivation layer 234 of the electroluminescent display device 200 according to the second embodiment of the present disclosure have the under-cut form, the light-emitting layer 242 separately formed in each of the pixel regions SP may be formed by one process.

The second electrode 243 configured to cover an upper surface and a side surface of the light-emitting layer 242 may be disposed.

The first electrode 241, the insulating pattern IP, the light-emitting layer 242, and the second electrode 243 may form each of the light emitting diodes D, and the light emitting diodes D may be separated from each other and disposed corresponding to the pixel regions SP, respectively.

The encapsulation layer 270 may be disposed on the light emitting diodes D formed corresponding to the pixel regions SP, respectively.

In this case, the encapsulation layer 270 may include an encapsulation film 271 having a first refractive index and a first partition wall PW1 having a second refractive index lower than the first refractive index.

In this case, the encapsulation film 271 may be disposed in the form in which the encapsulation film 271 covers each of the light emitting diodes D formed corresponding to each of the pixel regions SP.

In this case, the encapsulation film 271 may be formed of an inorganic film and/or have a multilayer structure.

Since the encapsulation film 271 has a structure in which the encapsulation film 271 covers each of the light emitting diodes D, permeation of oxygen or moisture into the light-emitting layer 242 and the second electrode 243 may be more effectively prevented.

A residual layer OM may be present between the light emitting diodes D.

In this case, the residual layer OM is formed from materials, which are to be used in forming the light emitting diodes D and the encapsulation film 271, remaining in the hole h1 of the interlayer insulating layer 228.

The first partition wall PW1 may be disposed between the encapsulation films 271 corresponding to the boundary between the pixel regions SP.

Although a middle portion of the first partition wall PW1 is illustrated as having a bar shape and an upper portion of the first partition wall PW1 is illustrated as having a shape in which a width progressively increases in the drawings, this is merely an example. The first partition wall PW1 may be formed such that the upper portion and the middle portion have the same width.

Also, a lower portion of the first partition wall PW1 of the electroluminescent display device 200 according to the second embodiment of the present disclosure may be formed to have a width larger than that of the middle portion, and a lower surface of the first partition wall PW1 may contact the residual layer OM.

In this case, a width d1 of the middle portion of the first partition wall PW1 may be in a range of 2 µm to 3 µm. The width of the upper portion of the first partition wall PW1 may be larger than or equal to the width d1 of the middle portion of the first partition wall PW1. However, embodiments are not limited thereto, and the size and form of the first partition wall PW1 may be modified in various ways according to the size, resolution, and the like of the pixel regions SP.

Also, a height HI of the first partition wall PW1 may be in a range of 7 µm to 9 µm, but embodiments are not limited thereto. The height HI may be modified in various ways according to a thickness or the like of the passivation layer 234, the interlayer insulating layer 228, and the light emitting diodes D.

In this case, the first partition wall PW1 may be an organic material having a second refractive index lower than the first refractive index of the encapsulation film 271. For example, the first refractive index may be in a range of 1.6 to 1.85, and the second refractive index may be in a range of 1.0 to 1.55, but embodiments are not limited thereto.

Due to the first partition wall PW1 having a refractive index lower than that of the encapsulation film 271, light that is incident obliquely on the encapsulation film 271 from the light-emitting layer 242 of the light emitting diodes D may be reflected by the first partition wall PW1 and be output upward. Accordingly, light extraction efficiency of the electroluminescent display device 200 may be improved, and color mixture may be prevented.

In addition, by forming the first partition wall PW1 between the encapsulation films 271 configured to respectively cover the light emitting diodes D, efficiency of preventing infiltration of oxygen and moisture into the light-emitting layer 242 and the second electrode 243 may be further improved.

Further, by the width of the lower portion of the first partition wall PW1 being formed larger than the width of the middle portion thereof and the lower surface of the first partition wall PW1 having a structure in which the lower surface contacts the residual layer OM, stability of the light emitting diodes D may be further improved.

The color filter layer 280 is disposed on the encapsulation layer 270.

In this case, the color filter layer 280 includes color filter patterns 281, 283, and 285 formed corresponding to the pixel regions SP, respectively, and a second partition walls PW2 formed between the color filter patterns 281, 283, and 285.

The color filter patterns 281, 283, and 285 have a third refractive index, and the second partition wall PW2 has a fourth refractive index lower than the third refractive index.

In this case, the third refractive index may be in a range of 1.6 to 1.85, and the fourth refractive index may be in a range of 1.0 to 1.55, but embodiments are not limited thereto.

A width d2 of a middle portion of the second partition wall PW2 may be in a range of 2 µm to 3 µm. The width of an upper portion of the second partition wall PW2 may be larger than or equal to the width d2 of the middle portion of the second partition wall PW2. However, embodiments are not limited thereto.

Also, a height H2 of the second partition wall PW2 may be in a range of 7 µm to 9 µm, but embodiments are not limited thereto. The height H2 may be modified in various ways according to a thickness or the like of the color filter patterns 281, 283, and 285.

The second partition wall PW2 may be formed of silicon oxide, but embodiments are not limited thereto. The second partition wall PW2 may also be formed of an air gap.

Due to the second partition wall PW2 having a refractive index lower than that of the color filter patterns 281, 283, and 285, light L2 that is incident obliquely on the color filter patterns 281, 283, and 285 from the light-emitting layer 242 of the light emitting diodes D may be reflected by the second partition wall PW2 and be output upward. Accordingly, a problem in which color mixture occurs in a viewing angle direction may be prevented.

Further, since the second partition wall PW2 between the color filter patterns 281, 283, and 285 has a relatively fine width d2, an emissive area may be increased in comparison to the conventional case in which a black matrix is disposed.

A scattering layer SL may be disposed on an upper surface of each of the color filter patterns 281, 283, and 285.

In this case, the scattering layer SL may be a concavo-convex pattern formed on the upper surface of each of the color filter patterns 281, 283, and 285, but embodiments are not limited thereto. The scattering layer SL may also be formed of a material layer including beads.

Accordingly, light that passes through the color filter patterns 281, 283, and 285 and is output to the outside may be scattered in various directions.

Particularly, by scattering a portion of light L3, which is incident vertically on the color filter patterns 281, 283, and 285 at a boundary between the pixel regions SP, toward the second partition wall PW2, perception of lattices that may occur due to the fine second partition wall PW2 being viewed as a black area may be prevented when one views an image in a state in which one's eyes are close to a screen, such as when one views an image using a VR device.

Particularly, the second partition wall PW2 of the electroluminescent display device 200 of FIG. 5 according to the second embodiment of the present disclosure is formed corresponding to the first partition wall PW1.

That is, the first partition wall PW1 and the second partition wall PW2 may be disposed to be parallel to each other in a first direction 1A perpendicular to the substrate 110.

Due to the first partition wall PW1 and the second partition wall PW2 being disposed to be parallel to each other in the first direction 1A, light that is output from the light emitting diodes D respectively formed in the pixel regions SP may be output to upper areas of the corresponding pixel regions SP. Accordingly, light extraction efficiency may be improved, and color mixture may be effectively prevented.

FIG. 6 is a graph schematically illustrating light extraction efficiency according to refractive indices of first and second partition walls according to the first and second embodiments of the present disclosure.

That is, FIG. 6 is a graph showing light extraction efficiency according to a change in refractive indices of first and second partition walls PW1 and PW2 of FIG. 5 when refractive indices of an encapsulation film 271 of FIG. 5 and color filter patterns 281, 283, and 285 of FIG. 5 are 1.7.

As illustrated in FIG. 6, it can be seen that light extraction efficiency increases as the refractive indices of the first and second partition walls PW1 and PW2 of FIG. 5 decreases from 1.55 to 1.4.

That is, it is shown that light extraction efficiency is 47 when the refractive indices of the first and second partition walls PW1 and PW2 of FIG. 5 are 1.55, light extraction efficiency is 51 when the refractive indices of the first and second partition walls PW1 and PW2 of FIG. 5 are 1.5, light extraction efficiency is 55.5 when the refractive indices of the first and second partition walls PW1 and PW2 of FIG. 5 are 1.45, and light extraction efficiency is 59 when the refractive indices of the first and second partition walls PW1 and PW2 of FIG. 5 are 1.4.

Accordingly, it can be seen that light extraction efficiency is the highest when the refractive indices of the first and second partition walls PW1 and PW2 of FIG. 5 are 1.4.

That is, a path of light that is obliquely output outward from light emitting diodes D may be adjusted through the first and second partition walls PW1 and PW2 of FIG. 5 and a largest amount of light may be output to the outside when the refractive indices of the first and second partition walls PW1 and PW2 of FIG. 5 are 1.4.

Accordingly, light extraction efficiency may be further improved by setting the refractive indices of the first and second partition walls PW1 and PW2 of FIG. 5 of the electroluminescent display device 100 of FIG. 2 and the electroluminescent display device 200 of FIG. 4 according to the first and second embodiments of the present disclosure to be 1.4.

In the present disclosure, a first partition wall having a low refractive index is disposed between light emitting diodes so that a path of light that is not output to the outside due to being totally reflected inside the light emitting diodes is changed and the light is allowed to be output to the outside. Accordingly, light extraction efficiency can be improved.

Further, a second partition wall having a low refractive index is disposed between color filter patterns so that a path of light that travels to an adjacent pixel region is changed and the light is allowed to be output to the corresponding pixel region. Accordingly, color mixture can be prevented.

## Claims

1. An electroluminescent display device comprising:
a substrate (110, 210) including a plurality of pixel regions (SP);
a plurality of light emitting diodes (D) spaced apart from each other on the substrate (110, 210) and corresponding to the plurality of pixel regions (SP), respectively;
an encapsulation film (171, 271) respectively covering the plurality of light emitting diodes (D) and having a first refractive index;
a first partition wall (PW1) disposed between the encapsulation film (171, 271) corresponding to a boundary between the plurality of pixel regions (SP) and having a second refractive index lower than the first refractive index; and
a color filter layer (180, 280) disposed on the encapsulation film (171, 271) and the first partition wall (PW1), wherein the color filter layer (180, 280) includes a plurality of color filter patterns (181, 183, 185; 281, 283, 285) having a third refractive index and a second partition wall (PW2) disposed between the plurality of color filter patterns (181, 183, 185; 281, 283, 285) and having a fourth refractive index lower than the third refractive index,
wherein the second partition wall (PW2) is disposed corresponding to the first partition wall (PW1), and
wherein the plurality of color filter patterns (181, 183, 185; 281, 283, 285) are disposed to correspond to the plurality of light emitting diodes (D), respectively.

2. The electroluminescent display device of claim 1, wherein a middle portion of each of the first partition wall (PW1) and/or the second partition wall (PW2) has a bar shape.

3. The electroluminescent display device of any one of the preceding claims, wherein an upper portion of each of the first partition wall (PW1) and the second partition wall (PW2) has a width which progressively increases upward.

4. The electroluminescent display device of claim 2 or 3, wherein
a width of the middle portion of each of the first partition wall (PW1) and/or the second partition wall (PW2) is in a range of 2 µm to 3 µm;
and/or
a height of each of the first partition wall (PW1) and/or the second partition wall (PW2) is in a range of 7 µm to 9 µm.

5. The electroluminescent display device as claimed in any one of the preceding claims, wherein each of the second refractive index and/or the fourth refractive index is in a range of 1.0 to 1.55.

6. The electroluminescent display device as claimed in any one of the preceding claims, wherein the color filter layer (180, 280) further includes a scattering layer (SL) disposed on an upper surface of each of the plurality of color filter patterns (181, 183, 185; 281, 283, 285); and/or an edge of each of the plurality of color filter patterns (181, 183, 185; 281, 283, 285) is curved.

7. The electroluminescent display device as claimed in any one of the preceding claims, wherein each of the plurality of light emitting diodes (D) includes:
a first electrode (141, 241) disposed on a passivation layer (134, 234);
an insulating pattern (IP) configured to cover an edge of the first electrode (141, 241);
a light-emitting layer (142, 242) disposed on the first electrode (141, 241) and the insulating pattern (IP); and
a second electrode (143, 243) disposed on the light-emitting layer (142, 242).

8. The electroluminescent display device of claim 7, further including an interlayer insulating layer (128, 228) disposed under the passivation layer (134, 234), wherein the passivation layer (134, 234) and the interlayer insulating layer (128, 228) for each pixel region (SP) are separated by the first partition wall (PW1).

9. The electroluminescent display device as claimed in any one of the preceding claims, wherein two adjacent light emitting diodes (D1, D2, and D3) are partitioned by a hole (h) in the passivation layer (134) and the interlayer insulating layer (128).

10. The electroluminescent display device as claimed in any one of the preceding claims, wherein an encapsulation layer (170) includes the encapsulation film (171) having the first refractive index and the first partition wall (PW1) having a second refractive index lower than the first refractive index.

11. The electroluminescent display device as claimed in claim 8, further comprising a hole (h) having different portions (h1) and (h2) configured to partition the pixel regions (SP1, SP2, SP3) in the interlayer insulating layer (228) and the passivation layer (234), wherein a width of a first portion (h1) is larger than a width of a second portion (h2).

## Patentansprüche

1. Elektrolumineszenzanzeigevorrichtung, die Folgendes umfasst:
ein Substrat (110, 210), das mehrere Pixelbereiche (SP) enthält;
mehrere lichtemittierende Dioden (D), die auf dem Substrat (110, 210) voneinander beabstandet sind und jeweils den mehreren Pixelbereichen (SP) entsprechen;
eine Einkapselungsschicht (171, 271), die jeweils die mehreren lichtemittierenden Dioden (D) bedeckt und einen ersten Brechungsindex besitzt;
eine erste Trennwand (PW1), die zwischen der Einkapselungsschicht (171, 271) angeordnet ist, die einer Grenze zwischen den mehreren Pixelbereichen (SP) entspricht und einen zweiten Brechungsindex besitzt, der niedriger als der erste Brechungsindex ist; und
eine Farbfilterschicht (180, 280), die auf der Einkapselungsschicht (171, 271) und der ersten Trennwand (PW1) angeordnet ist, wobei die Farbfilterschicht (180, 280) mehrere Farbfiltermuster (181, 183, 185; 281, 283, 285), die einen dritten Brechungsindex besitzen, und eine zweite Trennwand (PW2), die zwischen den mehreren Farbfiltermustern (181, 183, 185; 281, 283, 285) angeordnet ist und einen vierten Brechungsindex besitzt, der niedriger als der dritte Brechungsindex ist, enthält;
wobei die zweite Trennwand (PW2) entsprechend der ersten Trennwand (PW1) angeordnet ist und
wobei die mehreren Farbfiltermuster (181, 183, 185; 281, 283, 285) so angeordnet sind, dass sie jeweils den mehreren lichtemittierenden Dioden (D) entsprechen.

2. Elektrolumineszenzanzeigevorrichtung nach Anspruch 1, wobei ein mittlerer Teil jeder der ersten Trennwand (PW1) und/oder der zweiten Trennwand (PW2) eine Stabform besitzt.

3. Elektrolumineszenzanzeigevorrichtung nach einem der vorhergehenden Ansprüche, wobei ein oberer Teil jeder der ersten Trennwand (PW1) und der zweiten Trennwand (PW2) eine Breite besitzt, die nach oben fortschreitend zunimmt.

4. Elektrolumineszenzanzeigevorrichtung nach Anspruch 2 oder 3, wobei
eine Breite des mittleren Teils jeder der ersten Trennwand (PW1) und/oder der zweiten Trennwand (PW2) in einem Bereich von 2 µm bis 3 µm liegt;
und/oder
eine Höhe jeder der ersten Trennwand (PW1) und/oder der zweiten Trennwand (PW2) in einem Bereich von 7 µm bis 9 µm liegt.

5. Elektrolumineszenzanzeigevorrichtung nach einem der vorhergehenden Ansprüche, wobei jeder des zweiten Brechungsindexes und/oder des vierten Brechungsindexes in einem Bereich von 1,0 bis 1,55 liegt.

6. Elektrolumineszenzanzeigevorrichtung nach einem der vorhergehenden Ansprüche, wobei die Farbfilterschicht (180, 280) ferner eine Streuschicht (SL) enthält, die auf einer oberen Fläche jedes der mehreren Farbfiltermuster (181, 183, 185; 281, 283, 285) angeordnet ist; und/oder ein Rand jedes der mehreren Farbfiltermuster (181, 183, 185; 281, 283, 285) gekrümmt ist.

7. Elektrolumineszenzanzeigevorrichtung nach einem der vorhergehenden Ansprüche, wobei jede der mehreren lichtemittierenden Dioden (D) enthält:
eine erste Elektrode (141, 241), die auf einer Passivierungsschicht (134, 234) angeordnet ist;
ein Isoliermuster (IP), das konfiguriert ist, einen Rand der ersten Elektrode (141, 241) zu bedecken;
eine Lichtemissionsschicht (142, 242), die auf der ersten Elektrode (141, 241) und dem Isoliermuster (IP) angeordnet ist; und
eine zweite Elektrode (142, 243), die auf der Lichtemissionsschicht (142, 242) angeordnet ist.

8. Elektrolumineszenzanzeigevorrichtung nach Anspruch 7, die ferner eine Zwischenschichtisolierschicht (128, 228) enthält, die unter der Passivierungsschicht (134, 234) angeordnet ist, wobei die Passivierungsschicht (134, 234) und die Zwischenschichtisolierschicht (128, 228) für jeden Pixelbereich (SP) durch die erste Trennwand (PW1) getrennt sind.

9. Elektrolumineszenzanzeigevorrichtung nach einem der vorhergehenden Ansprüche, wobei zwei benachbarte lichtemittierende Dioden (D1, D2 und D3) durch eine Loch (h) in der Passivierungsschicht (134) und der Zwischenschichtisolierschicht (128) partitioniert sind.

10. Elektrolumineszenzanzeigevorrichtung nach einem der vorhergehenden Ansprüche, wobei eine Einkapselungsschicht (170) die Einkapselungsschicht (171), die den ersten Brechungsindex besitzt, und die erste Trennwand (PW1), die einen zweiten Brechungsindex besitzt, der niedriger als der erste Brechungsindex ist, enthält.

11. Elektrolumineszenzanzeigevorrichtung nach Anspruch 8,
die ferner ein Loch (h) umfasst, das verschiedene Teile (h1) und (h2) besitzt, die konfiguriert sind, die Pixelbereiche (SP1, SP2, SP3) in die Zwischenschichtisolierschicht (228) und die Passivierungsschicht (234) zu partitionieren, wobei eine Breite eines ersten Teils (h1) größer als eine Breite eines zweiten Teils (h2) ist.

## Revendications

1. Dispositif d'affichage électroluminescent comportant :
un substrat (110, 210) incluant une pluralité de régions de pixels (SP) ;
une pluralité de diodes électroluminescentes (D) espacées les unes des autres sur le substrat (110, 210) et correspondant à la pluralité de régions de pixels (SP), respectivement ;
un film d'encapsulation (171, 271) recouvrant respectivement la pluralité de diodes électroluminescentes (D) et ayant un premier indice de réfraction ;
une première paroi de séparation (PW1) disposée entre le film d'encapsulation (171, 271) correspondant à une frontière entre la pluralité de régions de pixels (SP) et ayant un deuxième indice de réfraction inférieur au premier indice de réfraction ; et
une couche de filtre à couleur (180, 280) disposée sur le film d'encapsulation (171, 271) et la première paroi de séparation (PW1), dans lequel la couche de filtre à couleur (180, 280) inclut une pluralité de motifs de filtre à couleur (181, 183, 185 ; 281, 283, 285) ayant un troisième indice de réfraction et une seconde paroi de séparation (PW2) disposée entre la pluralité de motifs de filtre à couleur (181, 183, 185 ; 281, 283, 285) et ayant un quatrième indice de réfraction inférieur au troisième indice de réfraction,
dans lequel la seconde paroi de séparation (PW2) est disposée en correspondance avec la première paroi de séparation (PW1), et
dans lequel les motifs de la pluralité de motifs de filtre à couleur (181, 183, 185 ; 281, 283, 285) sont disposés de manière à correspondre à la pluralité de diodes électroluminescentes (D), respectivement.

2. Dispositif d'affichage électroluminescent selon la revendication 1, dans lequel une partie centrale de chaque paroi parmi la première paroi de séparation (PW1) et/ou la seconde paroi de séparation (PW2) a une forme de barre.

3. Dispositif d'affichage électroluminescent selon l'une quelconque des revendications précédentes, dans lequel une partie supérieure de chaque paroi parmi la première paroi de séparation (PW1) et la seconde paroi de séparation (PW2) a une largeur qui augmente progressivement vers le haut.

4. Dispositif d'affichage électroluminescent selon la revendication 2 ou 3, dans lequel
une largeur de la partie centrale de chaque paroi parmi la première paroi de séparation (PW1) et/ou la seconde paroi de séparation (PW2) est dans un intervalle de 2 µm à 3 µm ;
et/ou
une hauteur de chaque paroi parmi la première paroi de séparation (PW1) et/ou la seconde paroi de séparation (PW2) est dans un intervalle de 7 µm à 9 µm.

5. Dispositif d'affichage électroluminescent selon l'une quelconque des revendications précédentes, dans lequel chaque indice parmi le deuxième indice de réfraction et/ou le quatrième indice de réfraction est dans un intervalle de 1,0 à 1,55.

6. Dispositif d'affichage électroluminescent selon l'une quelconque des revendications précédentes, dans lequel la couche de filtre à couleur (180, 280) inclut en outre une couche de diffusion (SL) disposée sur une surface supérieure de chaque motif parmi la pluralité de motifs de filtre à couleur (181, 183, 185 ; 281, 283, 285) ; et/ou un bord de chaque motif parmi la pluralité de motifs de filtre à couleur (181, 183, 185 ; 281, 283, 285) est incurvé.

7. Dispositif d'affichage électroluminescent selon l'une quelconque des revendications précédentes, dans lequel chaque diode parmi la pluralité de diodes électroluminescentes (D) inclut :
une première électrode (141, 241) disposée sur une couche de passivation (134, 234);
un motif isolant (IP) configuré pour recouvrir un bord de la première électrode (141, 241) ;
une couche émettrice de lumière (142, 242) disposée sur la première électrode (141, 241) et le motif isolant (IP) ; et
une seconde électrode (143, 243) disposée sur la couche émettrice de lumière (142, 242).

8. Dispositif d'affichage électroluminescent selon la revendication 7, incluant en outre une couche d'isolation intercouche (128, 228) disposée sous la couche de passivation (134, 234), dans lequel la couche de passivation (134, 234) et la couche d'isolation intercouche (128, 228) pour chaque région de pixel (SP) sont séparées par la première paroi de séparation (PW1).

9. Dispositif d'affichage électroluminescent selon l'une quelconque des revendications précédentes, dans lequel deux diodes électroluminescentes (D1, D2 et D3) adjacentes sont séparées par un trou (h) dans la couche de passivation (134) et la couche d'isolation intercouche (128).

10. Dispositif d'affichage électroluminescent selon l'une quelconque des revendications précédentes, dans lequel une couche d'encapsulation (170) inclut le film d'encapsulation (171) ayant le premier indice de réfraction et la première paroi de séparation (PW1) ayant un deuxième indice de réfraction inférieur au premier indice de réfraction.

11. Dispositif d'affichage électroluminescent selon la revendication 8, comportant en outre un trou (h) ayant différentes parties (h1) et (h2) configurées pour séparer les régions de pixels (SP1, SP2, SP3) dans la couche d'isolation intercouche (228) et la couche de passivation (234), dans lequel une largeur d'une première partie (h1) est supérieure à une largeur d'une seconde partie (h2).
